# EUROPEAN PATENT APPLICATION

(11) **EP 3 217 198 A1**
(43) Date of publication of application: **13.09.2017**
(21) Application number: 16305265.7
(22) Date of filing: 09.03.2016
(51) Int. Cl.: G02B 6/125, G02B 6/12, H01S 5/14, G02B 6/293

(54) **APPARATUS FORMING AN OPTICAL PASS BAND FILTER AND METHOD TO REALIZE THIS APPARATUS**

(71) Applicant: ALCATEL LUCENT, 92100 Boulogne-Billancourt (FR)
(72) Inventor: BOLLE, Cristian, MURRAY HILL, NJ 07974-0636 (US); GAO, Yongkang, MURRAY HILL, NJ 07974-0636 (US)
(74) Representative: Berthier, Karine

(57) **Abstract**

Apparatus forming an optical pass band filter and method to realize this apparatus. The apparatus comprises a substrate having a planar surface and first (201), second (202), and third (202) optical waveguide segments located along the planar surface and first (204) and second (205) optical reflectors being respectively located in the vicinity of first and second ends of the first optical waveguide segment (201). Within this apparatus, a portion (206) of the second optical waveguide segment (202) is arranged to be optically coupled with a portion of the first optical waveguide segment (201) and a portion (207) of the third optical waveguide segment (203) is arranged to be optically coupled with another portion of the first optical waveguide segment (201).

## Description

### FIELD OF INVENTION

The present subject matter relates to optical filters more specifically to optical filters based on Planar Lightwave Circuits (PLCs).

### BACKGROUND

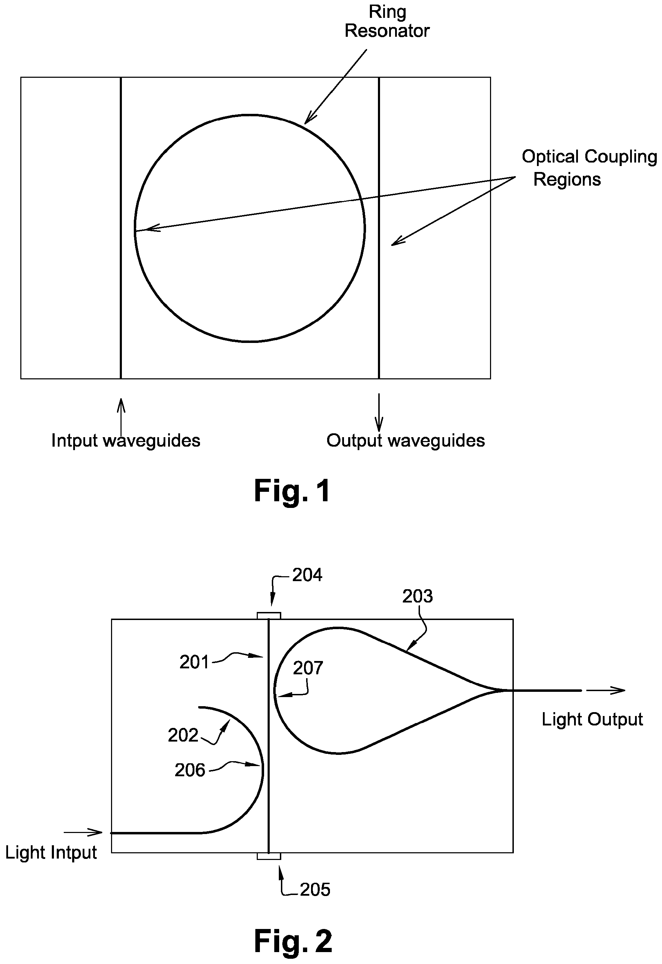

Figure 1 presents an optical filter of the state of the art. This optical filter is based on a PLC with a ring resonator. Two optical waveguides are placed in close proximity to a ring shaped optical waveguide. If light is sent into one of the waveguides some of the light evanescently couples to the ring and, in turn, will evanescently couple from the ring to the second waveguide. The transmission spectrum from the first waveguide to the second waveguide typically looks like the transmission spectrum of a Fabri-Perot interferometer.

This optical filter is typically limited by size induced optical losses. In particular to increase the Free Spectral Range (FSR) of the optical filter, the ring resonator may be made of a smaller size. But ring resonators of small size typically have high optical loss increases due to the small bending radius of the ring waveguide.

It is also known the US Patent Application reference US2015/0215043. This patent application describes embodiments of lasers based on optical ring-resonators.

### SUMMARY

Various embodiments propose optical filters that can solve the previously described problems. More specifically, some embodiments provide an optical filter with a small optical cavity and thus, are characterized by a large FSR. Nevertheless, some such embodiments have low optical losses, because the resonant cavities do not have an optical waveguide with a small bending radius.

This summary is provided to introduce concepts related to examples of optical filters.

In one implementation, an apparatus is described. The apparatus comprises a substrate having a planar surface and first, second, and third optical waveguide segments located along the planar surface and first and second optical reflectors being respectively located in the vicinity of first and second ends of the first optical waveguide segment. Wherein, within this apparatus, a portion of the second optical waveguide segment is arranged to be optically coupled with a portion of the first optical waveguide segment and a portion of the third optical waveguide segment is arranged to be optically coupled with another portion of the first optical waveguide segment.

In one implementation, an optical transmitter is described. This optical transmitter comprises the apparatus previously described.

In one implementation, an optical receiver is described. This optical receiver comprises the apparatus previously described.

In one implementation, a laser is described. This laser comprises the apparatus previously described and a semi-conductor optical amplifier.

In one implementation a method to realize an optical bandpass filter is described. The method comprises a step of etching a first layer of glass of a multi-layers structure, the multi-layers structure comprising a layer of silicon substrate a layer of Silicon Dioxide and the first layer of glass, to realize the first, second and third optical waveguides segments cores and a step of depositing a second layer of glass over the first layer to form an optical cladding layer for the waveguide cores and a step of forming reflective faces at both ends of a segment of one of the waveguides to produce an optical cavity.

### BRIEF DESCRIPTION OF THE FIGURES

The detailed description is given with reference to the accompanying figures. In the figures, the left-most digit(s) of a reference number identifies the figure in which the reference number first appears. The same numbers are used throughout the figures to reference like features and components. Some embodiments of system and/or methods in accordance with embodiments of the present subject matter are now described, by way of example only, and with reference to the accompanying figures, in which:
Figure 1 presents a conventional optical filter, which is based on a ring resonator.
Figure 2 presents a first embodiment of a PLC for an optical filter.
Figure 3 presents a second embodiment of a PLC for an optical filter.
Figure 4 presents a first method to realize PLCs for example the PLCs of figure 2 or 3.
Figure 5 presents a second method to realize PLCs for example the PLCs of figure 2 or 3.

In the present document, the word "exemplary" is used herein to mean "serving as an example, instance, or illustration." Any embodiment or implementation of the present subject matter described herein as "exemplary" is not necessarily to be construed as preferred or advantageous over other embodiments.

### DESCRIPTION OF EMBODIMENTS

The figure 2 presents an embodiment of the apparatus of the present subject matter. The apparatus comprises a substrate with a planar surface. The apparatus also comprises first 201, second 202, and third 203 optical waveguide segments located along the planar surface. The apparatus also comprises first 204 and second 205 optical reflectors; these optical reflectors are respectively located in the vicinity of first and second ends of the first 201 optical waveguide segment. A 206 portion of the second 202 optical waveguide segment is arranged to be optically coupled with a portion 206 of the first 201 optical waveguide segment. A portion 207 of the third 203 optical waveguide segment is arranged to be optically coupled with another portion 207 of the first 201 optical waveguide segment.

In the embodiment of the previous section the first optical waveguide segment is an optical cavity waveguide. This cavity waveguide and the two optical reflectors form a resonant cavity. The two optical reflectors are also known as mirrors. The second optical waveguide is an input waveguide and the third optical waveguide segment is an output waveguide. The coupling of the input waveguide with the cavity waveguide and the coupling of the output waveguide and the cavity waveguide can be made anywhere along these waveguides.

In an embodiment of the apparatus, a first end of the second 202 optical waveguide segment is an input of the apparatus and a first end of the third 203 optical waveguide segment is an output of the apparatus.

In an embodiment of the apparatus the first 204 and second 205 optical reflectors are located to form ends of an optical cavity including the first 201 optical waveguide segment.

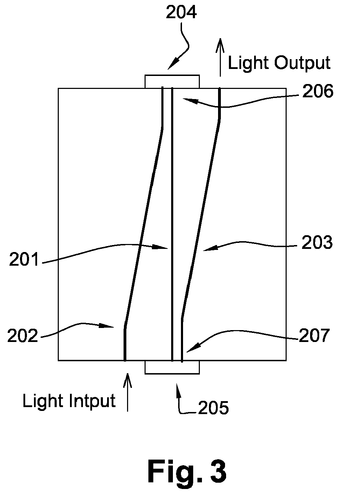

The figure 3 presents another embodiment of the apparatus of the present subject matter. In this embodiment a second end of the second 202 optical waveguide segment is located in the vicinity of the first 204 optical reflector. A second end of the third 203 optical waveguide segment is located in the vicinity of the second 205 optical reflector. The portions 206 of the first 201 and second 202 optical waveguides, optically coupled, are located in the vicinity of the first 204 optical reflector and are optically coupled by evanescent light. The portions 207 of the first 201 and third 203 optical waveguides, optically coupled, are located in the vicinity of the second 205 optical reflector and are optically coupled by evanescent light.

By coupled by evanescent light, we mean that both waveguides are close enough to each other so that light from one waveguide can cross over to the other waveguide.

In other words, in the embodiment of the previous section, the coupling regions are realized by the proximity of the input and output waveguides to the straight waveguide to couple light in and out of it. The end mirrors of the cavity are used at the same time by the input and output waveguides.

According to another embodiment at least one of the optical reflectors 204 and/or 205 includes a portion of a facet of the substrate at an edge of the planar surface.

According to another embodiment each of the optical reflectors 204 and 205 includes a portion of a facet of the substrate at an edge of the planar surface.

According to another embodiment at least one of the optical reflectors 204 and/or 205 includes an optical Bragg grating reflector.

According to another embodiment the first 201 optical waveguide and the first and second optical reflectors 204 and 205 form an optical bandpass filter.

An embodiment of the present subject matter is an optical system. This optical system comprises the optical bandpass filter of the previously described embodiments. This optical system can for example be an optical transmitter or an optical receiver. This optical bandpass filter will enable the use of lower power optical sources and so will have a lower power budget during operation. This optical bandpass filter will also enable the conception of more compact optical receivers or optical transmitters.

Another embodiment of the present subject matter is a laser. This laser comprises an optical band pass filter of one of the previous embodiments and a Semiconductor Optical Amplifier (SOA).

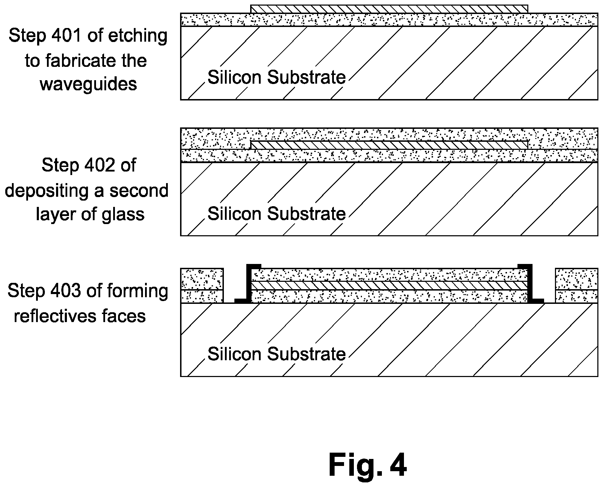

Another embodiment of the present subject matter is a method to produce the apparatus presented above. This method is described within the figure 4 and comprises:
- a step 401 of etching a first layer of glass of a multi-layers structure, the multi-layers structure comprising a layer of silicon substrate a layer of Silicon Dioxide and the first layer of glass, to realize the first, second and third optical waveguides segments cores and;
- a step 402 of depositing a second layer of glass over the first layer to form an optical cladding layer for the waveguide cores and;
- a step 403 of forming reflective faces at both ends of a segment of one of the waveguides to produce an optical cavity;

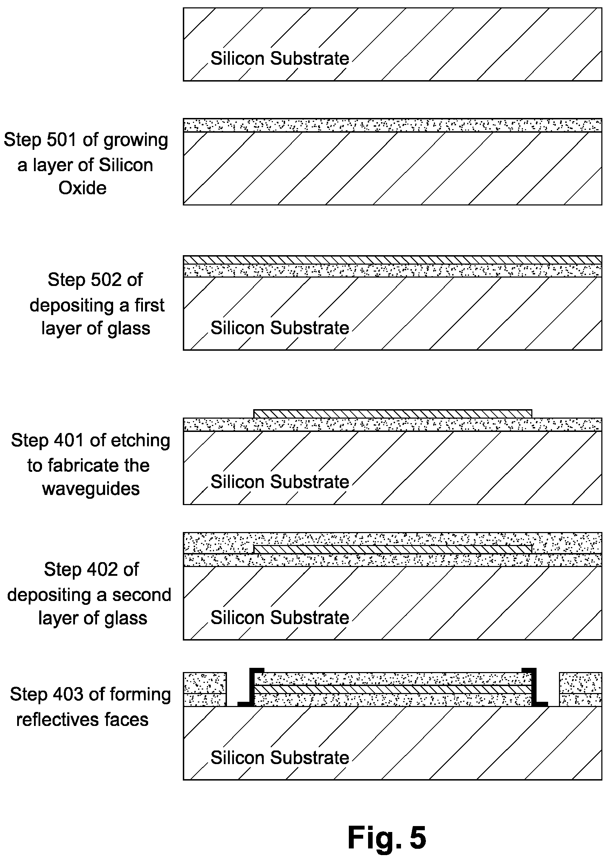

In an embodiment, presented in figure 5, the method of the previous section also comprises the two following initial steps:
- a step 501 of growing a layer of silicon dioxide over a silicon substrate
- a step 502 of depositing a first layer of glass over the layer of silicon dioxide.

The aim of these two steps is to realize the multi-layers structure.

In an embodiment, the step 405 of forming reflective faces comprises;
- a step of etching the first and second layer of glass to realize cavities at both ends of the segment of one of the waveguides;
- a step of coating at least one sidewalls of each cavities with a metal layer.

Within this embodiment the layer of silicon oxide over the silicon substrate will be a lower cladding. The two layers of glass can for example be made of doped silicon oxide and allow the control of the index of refraction of the layer and melting temperature of this layer. The first layer of glass will be used to define the waveguides by etching. The second layer of glass will be an upper cladding. The metal layer added by coating of the sidewall of the cavities are the first 204 and second 205 optical reflectors of the apparatus of the previously described embodiment.

This fabrication method does not require working with a chip that is as wide as the resonant cavity is long, polish two sides and metalize it. Indeed it allows incorporating the resonant cavity into a larger chip, in any place of the chip.

## Claims

1. An apparatus, comprising
• a substrate having a planar surface;
• first (201), second (202), and third (203) optical waveguide segments located along the planar surface and;
• first (204) and second (205) optical reflectors being respectively located in the vicinity of first and second ends of the first (201) optical waveguide segment; and
wherein:
• a portion (206) of the second (202) optical waveguide segment being arranged to be optically coupled with a portion (206) of the first (201) optical waveguide segment and
• a portion (207) of the third (203) optical waveguide segment being arranged to be optically coupled with another portion (207) of the first (201) optical waveguide segment.

2. Apparatus according to claim 1 wherein;
• a first end of the second (202) optical waveguide segment being an input of the apparatus and
• a first end of the third (203) optical waveguide segment being an output of the apparatus

3. Apparatus according to claim 1 or 2 wherein the first (204) and second (205) optical reflectors being located to form ends of an optical cavity including the first (201) optical waveguide segment.

4. Apparatus according to the claim 1 or 2 or 3
• wherein a second end of the second (202) optical waveguide segment being located in the vicinity of the first (204) optical reflector
• wherein a second end of the third (203) optical waveguide segment being located in the vicinity of the second (205) optical reflector
• wherein the optically coupled portions (206) of the first (201) and second (202) optical waveguide segments being located in the vicinity of the first (204) optical reflector and being optically coupled by evanescent light
• wherein the optically coupled portions (207) of the first (201) and third (203) optical waveguide segments being located in the vicinity of the second (205) optical reflector and being optically coupled by evanescent light.

5. Apparatus according to the claim 1 or 2 or 3 or 4, wherein at least one of the optical reflectors (204 and/or 205) includes a portion of a facet of the substrate at an edge of the planar surface.

6. Apparatus according to the claim 1 or 2 or 3 or 4, wherein each of the optical reflectors (204 and 205) includes a portion of a facet of the substrate at an edge of the planar surface.

7. Apparatus according to the claim 1 or 2 or 3 or 4, wherein at least one of the optical reflectors (204 and/or 205) includes an optical Bragg grating.

8. Apparatus according to the claim 1 or 2 or 3 or 4, wherein the first (201) optical waveguide and the first and second optical reflectors (204 and 205) form an optical bandpass filter.

9. Optical transmitter comprising the apparatus according to any of the claims 1 to 8.

10. Optical receiver comprising the apparatus according to any of the claims 1 to 8.

11. Laser comprising the apparatus according to any of the claims 1 to 8 and a semi-conductor optical amplifier.

12. Method to realize an optical bandpass filter, the method comprising;
a step (401) of etching a first layer of glass of a multi-layers structure, the multi-layers structure comprising a layer of silicon substrate a layer of Silicon Dioxide and the first layer of glass, to realize the first, second and third optical waveguides segments cores and;
a step (402) of depositing a second layer of glass over the first layer to form an optical cladding layer for the waveguide cores and;
a step (403) of forming reflective faces at both ends of a segment of one of the waveguides to produce an optical cavity.

13. Method according to the claim 12 also comprising the two following initial steps:
a step (501) of growing a layer of silicon dioxide over a silicon substrate
a step (502) of depositing a first layer of glass over the layer of silicon dioxide.

14. Method according to the claim 12 or 13 wherein the step (405) of forming reflective faces comprising;
a step of etching the first and second layer of glass to realize cavities at both ends of the segment of one of the waveguides;
a step of coating at least one sidewalls of each of the cavities with a metal layer.
